# EUROPEAN PATENT SPECIFICATION

(11) **EP 3 399 533 B1**
(45) Date of publication and mention of the grant of the patent: **21.10.2020**
(21) Application number: 16882038.9
(22) Date of filing: 23.12.2016
(51) Int. Cl.: H01H 9/54, H01H 33/59, H02H 3/00, G01R 19/165, H02H 3/02, H02H 3/353, G01R 19/175

(54) **METHOD AND DEVICE FOR CONTROLLING OPENING/CLOSING OF CIRCUIT BREAKER**
VERFAHREN UND VORRICHTUNG ZUM STEUERN DES ÖFFNENS/SCHLIESSENS EINES LEISTUNGSSCHALTERS
PROCÉDÉ ET DISPOSITIF DE COMMANDE D'OUVERTURE/FERMETURE DE DISJONCTEUR

(30) Priority: 30.12.2015 KR 20150190257
(43) Date of publication of application: 07.11.2018
(73) Proprietor: Hyosung Heavy Industries Corporation, Seoul 04144 (KR)
(72) Inventor: KWON, Young Jin, Uiwang-si, Gyeonggi-do 16028 (KR); KWON, Ki Ryang, Seoul 06920 (KR)
(74) Representative: Viering, Jentschura & Partner mbB Patent- und Rechtsanwälte
(86) International application number: PCT/KR2016/015211
(87) International publication number: WO 2017/116086

(56) References cited:
- EP-A1- 2 876 765
- WO-A1-2012/014282
- DE-B- 1 090 289
- JP-A- 2011 015 583
- JP-A- 2011 015 583
- KR-A- 20070 057 572
- KR-A- 20070 057 572
- KR-A- 20100 001 926
- KR-A- 20110 075 222
- KR-A- 20150 142 546
- US-A- 4 045 822
- US-A1- 2008 294 353

## Description

### FIELD OF THE INVENTION

The present invention relates to a method of, and a device for, controlling opening and closing a circuit breaker, and more particularly, to controlling the circuit breaker by minimizing noise impact on a zero-crossing detect. In other words, the present invention relates to the method of, and the device for, controlling the opening and closing of the circuit breaker without any delay by minimizing noise impact over the zero-crossing detect.

### BACKGROUND OF THE INVENTION

In general, a circuit breaker or CB refers to a device of keeping safety by performing a function of supplying which supplies power to load and a function of opening which turns off a load circuit upon fault occurrence.

Generally, because a sinusoidal AC waveform is mainly used for a power line of a power grid, when a circuit breaker is suddenly opened, a switching surge such as an arc caused by transients may occur on the circuit breaker. Such opening and closing surge may shorten the lifecycle of the circuit breaker by degrading its performance. In addition, when the time goes by, the circuit breaker becomes obsolete, it is impossible to accurately open and close the circuit breaker. Therefore, a lot of studies on technology of controlling opening and closing of a circuit breaker have been made.

For example, Korean Patent Laid-Open Publication No. 10-2005-0117193 proposes a device for controlling opening and closing a circuit breaker to which a power semiconductor device is applied in order to control opening and closing the circuit breaker in any circumstances, comprising a means for driving the circuit breaker composed of a FET driving unit and a relay driving unit with a fast switching speed in parallel to minimize delay of operating time of an opening and closing controller, thereby causing rapid control of the opening and closing the circuit breaker and to allow the relay driving unit connected in parallel to operate the circuit breaker upon failure in the FET driving unit.

However, even in this case, it is impossible to prevent the noise impact over the zero-crossing detect. Therefore, it may delay controlling the opening and closing of the circuit breaker or cause a malfunction thereof.

US-A-4045822 discloses a method of controlling opening and closing of a circuit breaker according to the preamble of claim 1 and a device for controlling opening and closing of a circuit breaker according to the preamble of claim 6.

### SUMMARY OF THE INVENTION

It is an object of the present invention to provide a method of, and a device for, controlling opening and closing a circuit breaker by minimizing noise impact over a zero-crossing detect.

It is the other object of the present invention to provide a method of, and a device for, controlling a circuit breaker that protects phase modifying equipment by performing a reliable operation without malfunction even in a poor environment of a substation while operating the circuit breaker without any delay by minimizing noise impact over zero-crossing detect based on an integral over a period.

These objects are achieved by a method of controlling opening and closing of a circuit breaker according to claim 1 and by a device for controlling opening and closing of a circuit breaker according to claim 6.

### BRIEF DESCRIPTION OF THE DRAWINGS

The drawings attached below to explain example embodiments of the present invention are only part of example embodiments of the present invention and other drawings may be obtained based on the drawings without inventive work for those skilled in the art:
Fig. 1 is a flowchart representing a method of controlling opening and closing a circuit breaker in accordance with one example embodiment of the present invention.
Fig. 2 is a drawing representing a case where a signal is distorted by noise.
Fig. 3 shows drawings representing cases where the present invention is applied to a signal in Fig. 2 and where a conventional method is applied.
Fig. 4 is a block diagram representing a device for controlling opening and closing of a circuit breaker in accordance with one example embodiment of the present invention.

### DETAILED DESCRIPTION OF THE PREFERRED EMBODIMENTS

Explanation of detailed example embodiments to execute the present invention is made by referring to attached drawings.

The present invention may make alternations and have several example embodiments. Therefore, specific example embodiments will be exemplified in drawings and used for detailed explanation. It may be understood that this is not intended to limit the present invention to the specific example embodiments and include all modifications, equivalents or alternatives included in the spirit and technical scope of the present invention.

A method of, and a device for, controlling opening and closing of a circuit breaker in accordance with the present invention are explained below in details by referring to attached drawings.

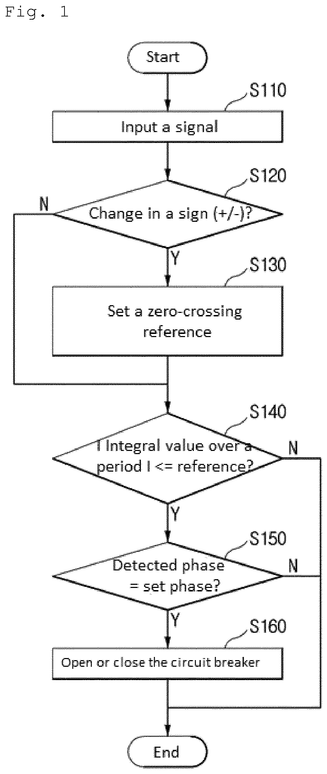

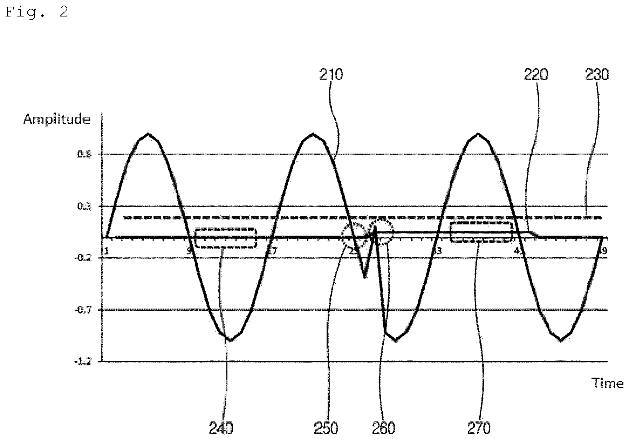

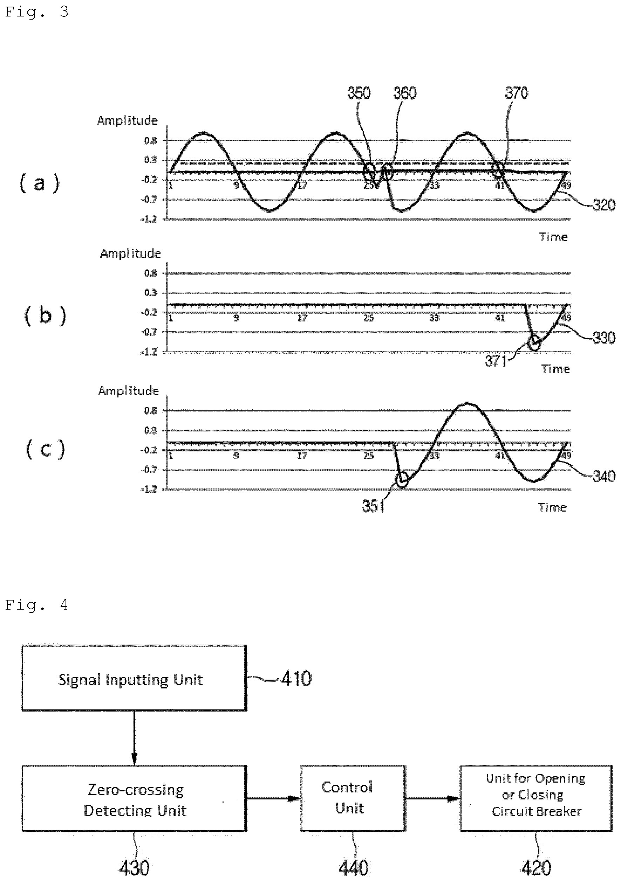

Fig. 1 is a flowchart representing a method of controlling opening and closing a circuit breaker in accordance with one example embodiment of the present invention and Figs. 2 and 3 are graphs to explain Fig. 1 in details.

By referring to Figs. 1 to 3, the method of controlling the opening and closing of the circuit breaker in accordance with one example embodiment of the present invention is explained.

By referring to Fig. 1, the method of controlling opening and closing of a circuit breaker in accordance with one example embodiment of the present invention comprises, first of all, steps of receiving a signal as S110, detecting change in a sign of the signal as S120, setting a zero-crossing reference when there is any change in the sign as S130, checking whether the absolute value of an integral over a period obtained by integrating the signal over a period exceeds the zero-crossing reference or not as S140, determining whether the detected phase is identical to a set phase as S150, and controlling the opening or the closing of the circuit breaker when the absolute value of the integral over a period does not exceed the reference and the detected phase is identical to the set phase as S160.

Herein, the reference as a specific positive value exceeding zero may be determined to be properly set depending on an environment and a situation of installing the circuit breaker such as amplitude of the signal or degree of noise. Besides, the set phase may be determined as a value between 0 degree and 360 degrees.

Meanwhile, it is desirable that the method of controlling the opening and closing of the circuit breaker in the present invention is applied to a circuit breaker for frequent phase modifying equipment switching that cuts off a voltage level of at least 1 kV.

In case of the conventional method of controlling the opening and closing of the circuit breaker, at the step of detecting the change in the sign as S120, the circuit breaker detects a zero-crossing regarding an inputted signal and at the step of opening and closing the circuit breaker as S160, the circuit breaker is controlled to be opened and closed at a set phase but at the time, when the zero-crossing occurs due to noise, a delay in controlling an opening and closing device occurs over at least one period because setting a zero-crossing reference is performed again at the step of setting the zero-crossing reference as S130.

Accordingly, when the absolute value of an integral over a period does not exceed a reference value at a step of comparing the integral over a period as $140 by making the integral based on the zero-crossing to minimize such delay in the present invention, to minimize such delay, it may be ignored by being considered as the zero-crossing by noise and the circuit breaker may be opened and closed at a set phase without any noise impact.

At the time, as explained above, the reference as a specific positive value exceeding zero may be determined to be properly set depending on an environment and a situation of installing the circuit breaker such as amplitude of the signal or degree of noise.

Fig. 2 is a drawing representing a case where a signal is distorted by noise. In general, a normal zero-crossing 250 in a voltage waveform 210 occurs every period. At this time, because a normal integral waveform 240 as an integral of a signal over a period becomes zero, opening and closing of the circuit breaker may be controlled based on the normal zero-crossing 250.

But, as shown in Fig. 2, if an abnormal zero-crossing 260 occurs by noise, an abnormal integral waveform 270 as an integral of the signal over a period does not become zero any longer and if the circuit breaker is controlled based on the abnormal zero-crossing 260, the circuit breaker may be damaged. Accordingly, the opening and closing of the circuit breaker may be controlled to prevent such damage by detecting the zero-crossing again but in this case, a delay over as much as a period may occur.

Therefore, in the present invention, if the abnormal integral waveform 270 does not exceed a reference 230, i.e., if the abnormal value of the integral over a period by integrating the signal over one period based on the zero-crossing does not exceed the reference 230, the abnormal zero-crossing 260 is determined as zero-crossing caused by noise, thereby being ignored. After that, the opening and closing of the circuit breaker is controlled based on the normal zero-crossing 250.

The method of controlling the opening and closing of the circuit breaker in the present invention may allow the opening and closing of the circuit breaker to be controlled without any delay over a period.

Fig. 3 shows drawings representing cases where the present invention is applied to a signal in Fig. 2 and where a conventional method is applied, wherein a set phase is -90 degrees, i.e., 270 degrees.

As shown in Fig. 3A, along an inputted signal 320 of the opening and closing device, an abnormal zero-crossing 360 other than a normal zero-crossing 350 caused by noise may occur.

According to the conventional method, when an abnormal zero-crossing 360 is detected, a next zero-crossing 370 is detected again. As seen in Fig. 3B, as the opening and closing of the circuit breaker is controlled after a phase is detected 371 based on a next zero-crossing 370 and whether the phase is identical to a set phase is checked, the control is delayed.

On the other hand, as seen in Fig. 3C, the present invention may prevent such delay by ignoring the abnormal zero-crossing 360 caused by noise even though the normal zero-crossing 350 and the abnormal zero-crossing 360 are detected, checking whether a phase detected 351 based on the normal zero-crossing 350 is identical to the set phase, and controlling the opening and closing of the circuit breaker.

Accordingly, the present invention may control the circuit breaker without any delay even though the abnormal zero-crossing 360 caused by noise occurs.

Fig. 4 is a block diagram representing a device for controlling opening and closing of a circuit breaker in accordance with one example embodiment of the present invention.

As seen in Fig. 4, the device for controlling opening and closing of the circuit breaker in the prevent invention includes a signal inputting unit 410 for receiving a signal, a unit 420 for opening and closing the circuit breaker, a zero-crossing detecting unit 430 for detecting change in a sign of the signal, and a control unit 440 for setting a zero-crossing reference when there is any change in the sign, checking whether the absolute value of an integral over a period obtained by integrating the signal over a period exceeds the zero-crossing reference or not, determining whether the detected phase is identical to a set phase, and thereby controlling a unit 420 for opening or closing a circuit breaker when the absolute value of the integral over a period does not exceed the reference and the detected phase is identical to the set phase.

As explained above, herein, the reference as a specific positive value exceeding zero may be determined to be properly set depending on an environment and a situation of installing the circuit breaker such as amplitude of the signal or degree of noise and the set phase may be determined as a value between 0 degree and 360 degrees. In addition, it is desirable that the device for controlling opening and closing of the circuit breaker in the present invention is applied to a circuit breaker for frequent phase modifying equipment switching that cuts off a voltage level of at least 1 kV.

The device for controlling opening and closing of the circuit breaker in the present invention first detects zero-crossing from a sign of the signal through the zero-crossing detecting unit 430 for detecting with respect to the inputted signal through the signal inputting unit 410.

After that, when integration is made based on the zero-crossing and the absolute value of an integral over one period does not exceed a reference value, the control unit 440 controls the opening and closing of the circuit breaker at a set phase through the unit 420 for opening and closing the circuit breaker.

Accordingly, the device for controlling opening and closing of the circuit breaker in the present invention may control the circuit breaker without any delay even though an abnormal zero-crossing caused by noise occurs.

As seen above, while being capable of operating the circuit breaker without any delay by minimizing noise impact upon zero-crossing detect based on the integral over a period, the method of, and the device for, controlling opening and closing the circuit breaker in accordance with the present invention may protect phase modifying equipment by performing a reliable operation without malfunction even in the poor environment of a substation.

The method of, and the device for, controlling opening and closing the circuit breaker in accordance with the present invention may control the circuit breaker by minimizing the noise impact upon the zero-crossing detect.

Furthermore, the present invention has an effect of protecting phase modifying equipment by performing a reliable operation without malfunction even in the poor environment of a substation while being capable of operating the circuit breaker without any delay by minimizing noise impact upon zero-crossing detect based on the integral over a period.

The The explained example embodiments include all alternatives, modifications, and changes without departing from the scope of the claims.

### INDUSTRIAL AVAILABILITY

The present invention which relates to a method of, and a device for, controlling opening and closing of a circuit breaker is available in a field of circuit breaker.

## Claims

1. A method of controlling opening and closing of a circuit breaker, comprising steps of:
receiving an inputted signal;
detecting change in a sign of the signal;
setting a zero-crossing reference when there is any change in the sign;
checking whether the absolute value of an integral over a period obtained by integrating the signal over a period exceeds the zero-crossing reference or not; **characterized by**
determining whether the detected phase is identical to a set phase; and
controlling the opening or the closing of the circuit breaker when the absolute value of the integral over a period does not exceed the reference and the detected phase is identical to the set phase.

2. The method of Claim 1, wherein, at the step of comparing the integral over a period, the reference is a specific positive value exceeding zero.

3. The method of Claim 1, wherein, at the step of comparing the integral over a period, the reference is determined based on at least either of amplitude of the signal or degree of noise.

4. The method of Claim 3, wherein the set phase is a value between 0 degree and 360 degrees.

5. The method of Claim 1, wherein the circuit breaker is a circuit breaker for frequent phase modifying equipment switching that cuts off a voltage level of at least 1 kV.

6. A device for controlling opening and closing of a circuit breaker, comprising:
a signal inputting unit for receiving a signal;
a unit for opening and closing the circuit breaker;
a zero-crossing detecting unit for detecting change in a sign of the signal; and
a control unit for setting a zero-crossing reference when there is any change in the sign, checking whether the absolute value of an integral over a period obtained by integrating the signal over a period exceeds the zero-crossing reference or not, **characterized by** determining whether the detected phase is identical to a set phase, and thereby controlling the opening or the closing of the circuit breaker when the absolute value of the integral over a period does not exceed the reference and the detected phase is identical to the set phase.

7. The device of Claim 6, wherein the reference is a specific positive value exceeding zero.

8. The device of Claim 6, wherein the reference is determined based on at least either of amplitude of the signal or degree of noise.

9. The device of Claim 6, wherein the set phase is a value between 0 degree and 360 degrees.

10. The device of Claim 6, wherein the circuit breaker is a circuit breaker for frequent phase modifying equipment switching that cuts off a voltage level of at least 1 kV.

## Patentansprüche

1. Verfahren zum Steuern eines Öffnen und Schließens eines Schutzschalters, aufweisend die Schritte:
Empfangen eines eingegebenen Signals;
Erfassen einer Änderung eines Vorzeichens des Signals;
Setzen einer Nulldurchgangs-Referenz, wenn es eine Änderung des Vorzeichens gibt;
Prüfen, ob der absolute Wert eines Integrals über eine Zeitdauer, die mittels Integrierens des Signals über eine Zeitdauer erhalten wird, die Nulldurchgang-Referenz überschreitet oder nicht; **gekennzeichnet durch** ein
Ermitteln, ob die erkannte Phase identisch zu einer vorgegebenen Phase ist; und
Steuern des Öffnens oder des Schließens des Schutzschalters, wenn der absolute Wert des Integrals über eine Zeitdauer nicht die Referenz überschreitet und die erfasste Phase identisch zu der vorgegebenen Phase ist.

2. Verfahren nach Anspruch 1, wobei bei dem Schritt des Vergleichens des Integrals über eine Zeitdauer die Referenz ein spezifischer positiver Wert ist, der größer als Null ist.

3. Verfahren nach Anspruch 1, wobei bei dem Schritt des Vergleichens des Integrals über eine Zeitdauer die Referenz basierend auf mindestens entweder eine Amplitude des Signals oder einem Grad des Rauschens ermittelt wird.

4. Verfahren nach Anspruch 3, wobei die vorgegebene Phase ein Wert zwischen 0 Grad und 360 Grad ist.

5. Verfahren nach Anspruch 1, wobei der Schutzschalter ein Schutzschalter für einen häufig eine Phase modifizierenden automatischen Schalter ist, der eine Spannung von mindestens ein 1 kV unterbricht.

6. Vorrichtung zum Steuern eines Öffnens und Schließens eines Schutzschalters, aufweisend:
eine Signaleingabeeinheit zum Empfangen eines Signals;
eine Einheit zum Öffnen und Schließen des Schutzschalters;
eine Nulldurchgangs-Erfassungseinheit zum Erfassen einer Änderung eines Vorzeichens des Signals;
und eine Steuereinheit zum Einstellen einer Nulldurchgangs-Referenz, wenn es eine Veränderung bei dem Vorzeichen gibt, die prüft, ob der absolute Wert eines Integrals über eine Zeitdauer, die erhalten wird mittels Integrierens des Signals über eine Zeitdauer, die Nulldurchgangs-Referenz überschreitet oder nicht, **gekennzeichnet durch**
ein Ermitteln, ob die erfasste Phase identisch zu einer vorgegebenen Phase ist, und dadurch Steuern des Öffnens oder Schließens des Schutzschalters, wenn der absolute Wert des Integrals über eine Zeitdauer nicht die Referenz überschreitet und die erfasste Phase mit der vorgegebenen Phase identisch ist.

7. Vorrichtung nach Anspruch 6, wobei die Referenz ein spezifischer positiver Wert ist, der größer null ist.

8. Vorrichtung nach Anspruch 6, wobei die Referenz basierend auf mindestens entweder einer Amplitude des Signals oder einem Grad eines Rauschens ermittelt wird.

9. Vorrichtung nach Anspruch 6, wobei die vorgegebene Phase ein Wert zwischen 0 Grad und 360 Grad ist.

10. Vorrichtung nach Anspruch 6, wobei der Schutzschalter ein Schutzschalter für einen häufig eine Phase modifizierenden automatischen Schalter ist, der eine Spannung von mindestens ein 1 kV unterbricht.

## Revendications

1. Procédé de contrôle de l'ouverture et de la fermeture d'un disjoncteur, comprenant les étapes suivantes :
réception d'un signal entrant ;
détection d'un changement de signe du signal ;
réglage d'une référence de passage à zéro lorsqu'il y a un changement de signe ;
vérification si la valeur absolue d'une intégrale sur une période obtenue en intégrant le signal sur une période dépasse la référence de passage à zéro ou non ;
**caractérisé par**
la détermination si la phase détectée est identique à une phase réglée ; et
le contrôle de l'ouverture ou de la fermeture du disjoncteur lorsque la valeur absolue de l'intégrale sur une période ne dépasse pas la référence et la phase détectée est identique à la phase réglée.

2. Procédé selon la revendication 1, dans lequel, à l'étape de comparaison de l'intégrale sur une période, la référence est une valeur positive spécifique supérieure à zéro.

3. Procédé selon la revendication 1, dans lequel, à l'étape de comparaison de l'intégrale sur une période, la référence est déterminée sur la base d'au moins l'amplitude du signal ou du degré de bruit.

4. Procédé selon la revendication 3, dans lequel la phase réglée est une valeur entre 0 degré et 360 degrés.

5. Procédé selon la revendication 1, dans lequel le disjoncteur est un disjoncteur pour la commutation d'un équipement de changements de phase fréquents qui coupe un niveau de tension d'au moins 1 kV.

6. Dispositif pour le contrôle de l'ouverture et de la fermeture d'un disjoncteur, comprenant :
une unité d'entrée de signal pour la réception d'un signal ;
une unité pour l'ouverture et de la fermeture du disjoncteur ;
une unité de détection de passage à zéro pour détecter un changement de signe du signal ; et
une unité de contrôle pour le réglage d'une référence de passage à zéro lorsqu'il y a un changement de signe, la vérification si la valeur absolue d'une intégrale sur une période obtenue en intégrant le signal sur une période dépasse la référence de passage à zéro ou non,
**caractérisé par**
la détermination si la phase détectée est identique à une phase réglée et ainsi le contrôle de l'ouverture ou de la fermeture du disjoncteur lorsque la valeur absolue de l'intégrale sur une période ne dépasse pas la référence et la phase détectée est identique à la phase réglée.

7. Dispositif selon la revendication 6, dans lequel la référence est une valeur positive spécifique supérieure à zéro.

8. Dispositif selon la revendication 6, dans lequel la référence est déterminée sur la base d'au moins l'amplitude du signal ou du degré de bruit.

9. Dispositif selon la revendication 6, dans lequel la phase réglée est une valeur entre 0 degré et 360 degrés.

10. Dispositif selon la revendication 6, dans lequel le disjoncteur est un disjoncteur pour la commutation d'un équipement de changements de phase fréquents qui coupe un niveau de tension d'au moins 1 kV.
